# EUROPEAN PATENT APPLICATION

(11) **EP 2 778 695 A1**
(43) Date of publication of application: **17.09.2014**
(21) Application number: 13275068.8
(22) Date of filing: 15.03.2013
(51) Int. Cl.: G01R 29/08

(54) **ASSESSMENT OF ELECTROMAGNETIC SCREENING**

(71) Applicant: BAE Systems PLC, London SW1Y 5AD (GB)
(72) Inventor: The designation of the inventor has not yet been filed
(74) Representative: BAE SYSTEMS plc Group IP Department

(57) **Abstract**

A method of providing an assessment of electromagnetic screening, the method comprising: providing a first electrical conductor; providing a second electrical conductor, the second electrical conductor being a different electrical conductor to the first electrical conductor; providing electromagnetic screening, the electromagnetic screening being arranged such that: electromagnetic radiation incident upon, or emitted by, the first conductor is blocked, by the electromagnetic screening, at least to some extent; and electromagnetic radiation incident upon, or emitted by, the second conductor is not blocked by the electromagnetic screening; measuring a current within either or both of the first and second electrical conductors induced by the electromagnetic radiation emitted ; and using the one or more measurements, determining an assessment of the electromagnetic screening.

## Description

### FIELD OF THE INVENTION

This invention relates to the assessment of electromagnetic screening or shielding.

### BACKGROUND

The protection of electrical/electronic systems and in particular interconnecting cable networks from electromagnetic hazards (EMH) is of great importance in aircraft.

Electromagnetic hazards include, but are not limited to, lightning, electromagnetic compatibility (EMC) (including the effects of high intensity/energy radiated fields (HIRF or HERF) and interoperability or electromagnetic interference (EMI)), electromagnetic pulse (EMP), effects arising from electrostatic discharge (ESD), etc.

There is a growing interest within the aircraft industry in through-life monitoring/measurement of the performance of electromagnetic shielding of installed electrical and electronic systems. This has become more important as more systems have been given flight safety authority, and airworthiness rules have been enforced on the inspection of cable and wire insulation and screening. Also, maintenance of the performance of cables is important for several reasons including: ensuring the integrity of a signal, power or grounding/earthing path; ensuring the integrity of the cable screening (as the survivability against lightning, EMC, EMP and electrostatic hazards are dependent on it); and ensuring that erosion of screening and insulation has not allowed conductors to contact each other or other structures, thereby increasing the possibility that arcs and sparks or Ohmic heating cause incipient fire.

Once installed there are currently no adequate techniques or technologies for the continued reassessment of the effectiveness or soundness of electromagnetic hazards protection of systems. Currently the methods available are visual inspection and loop impedance testing which are both capable only of discovering gross variations.

Methods currently available include that disclosed in US-A-6,995,565, which discloses applying an electrolytic fluid to wires or cables, passing a current through the wire and using a thermal imaging system to detect heat from the wire which may indicate damage to a wire. GB-A-2250100 and GB-A-2227845 disclose electric test methods for testing the integrity of wires and cables. These methods are in general very time consuming to carry out on large aircraft having a large network of cables, which may be installed in remote and difficult positions to access.

### SUMMARY OF THE INVENTION

In a first aspect, the present invention provides a method of providing an assessment of electromagnetic screening, the method comprising: providing a first electrical conductor; providing a second electrical conductor, the second electrical conductor being a different electrical conductor to the first electrical conductor; providing a third electrical conductor; providing electromagnetic screening, the electromagnetic screening being arranged such that: electromagnetic radiation incident upon, or emitted by, the first conductor is blocked, by the electromagnetic screening, at least to some extent; and electromagnetic radiation incident upon, or emitted by, the second conductor is not blocked by the electromagnetic screening; applying, to the third conductor, a test signal, thereby causing the third conductor to emit electromagnetic radiation; measuring a current within either or both of the first and second electrical conductors induced by the electromagnetic radiation emitted by the third conductor; and using the one or more measurements, determining an assessment of the electromagnetic screening.

The second electrical conductor and the third electrical conductor may be the same electrical conductor. The step of measuring may comprise measuring a current induced within the first electrical conductor by the electromagnetic radiation emitted from the second conductor.

The third electrical conductor may be a different electrical conductor to the first and second electrical conductors. The step of measuring may comprise measuring a current within both of the first and second electrical conductors. The step of determining an assessment may comprise, using the measurements, determining a coupling between the first and second electrical conductors, and using the determined coupling, determining an assessment of the electromagnetic screening.

The step of determining an assessment may further comprise comparing the determined coupling to a predetermined benchmark, the predetermined benchmark being indicative of the electromagnetic screening operating as desired.

The first electrical conductor and the electromagnetic screening may be components of a cable. The first electrical conductor may be an internal conductor within the electromagnetic screening. The electromagnetic screening may be a coaxial screening housing the first electrical conductor.

The second electrical conductor may be a conductor embedded into an external jacket of the cable such that it is outside the electromagnetic screening.

The first electrical conductor and the third electrical conductor may be the same electrical conductor. The step of measuring may comprise measuring a current induced within the second electrical conductor by the electromagnetic radiation emitted from the first conductor.

The step of determining an assessment may comprise comparing the measuring induced current to a predetermined benchmark, the predetermined benchmark being indicative of the electromagnetic screening operating as desired.

The first electrical conductor and the electromagnetic screening may be components of a cable. The first electrical conductor may be an internal conductor within the electromagnetic screening. The electromagnetic screening may be a coaxial screening housing the first electrical conductor.

The second electrical conductor may be a conductor that is remote from the cable and may be moved away from the cable after the determination of the assessment of the electromagnetic screening.

The test signal may be a pseudo random binary signal.

In a further aspect, the present invention provides apparatus comprising: a first electrical conductor; a second electrical conductor, the second electrical conductor being a different electrical conductor to the first electrical conductor; a third electrical conductor; electromagnetic screening arranged such that: electromagnetic radiation incident upon, or emitted by, the first conductor is blocked, by the electromagnetic screening, at least to some extent, and electromagnetic radiation incident upon, or emitted by, the second conductor is not blocked by the electromagnetic screening; a signal source configured to apply, to the third conductor, a test signal, thereby causing the third conductor to emit electromagnetic radiation; a sensor operatively coupled to either or both of the first and second electrical conductors and configured to measure a current within the electrical conductors to which the sensor is coupled that has been induced by the electromagnetic radiation emitted by the third conductor; and a processor operatively coupled to the sensor and configured to, using the one or more sensor measurements, determine an assessment of the electromagnetic screening.

In a further aspect, the present invention provides an aircraft comprising apparatus in accordance with the preceding aspect.

In a further aspect, the present invention provides a program or plurality of programs arranged such that when executed by a computer system or one or more processors it/they cause the computer system or the one or more processors to operate in accordance with the method of any of the above aspects.

In a further aspect, the present invention provides a machine readable storage medium storing a program or at least one of the plurality of programs according to the preceding aspect.

### BRIEF DESCRIPTION OF THE DRAWINGS

Figure 1 is a schematic illustration (not to scale) showing an embodiment of a cable wiring system.
Figure 2 is a process flow chart showing certain steps of a process of assessing the integrity of the electromagnetic screening of a cable of the cable wiring system of Figure 1;
Figure 3 is a schematic illustration (not to scale) showing a further embodiment of a cable wiring system; and

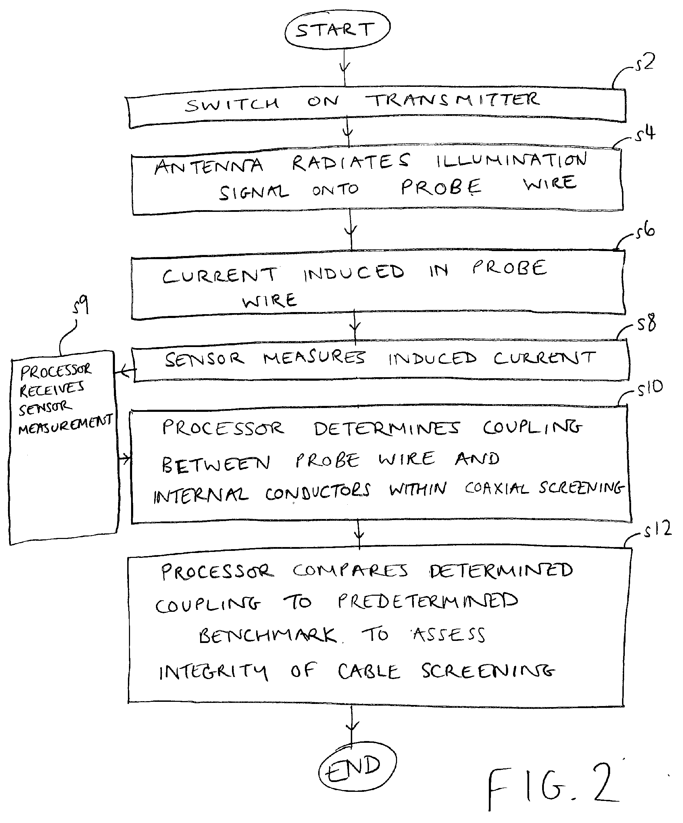

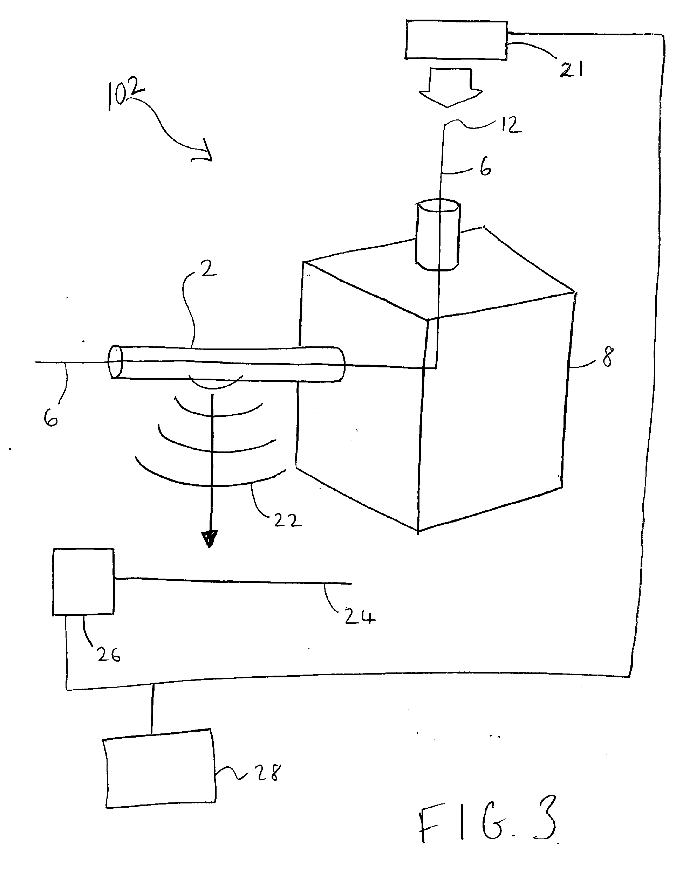

Figure 2 is a process flow chart showing certain steps of a process of assessing the integrity of the electromagnetic screening of a cable of the cable wiring system of Figure 3.

### DETAILED DESCRIPTION

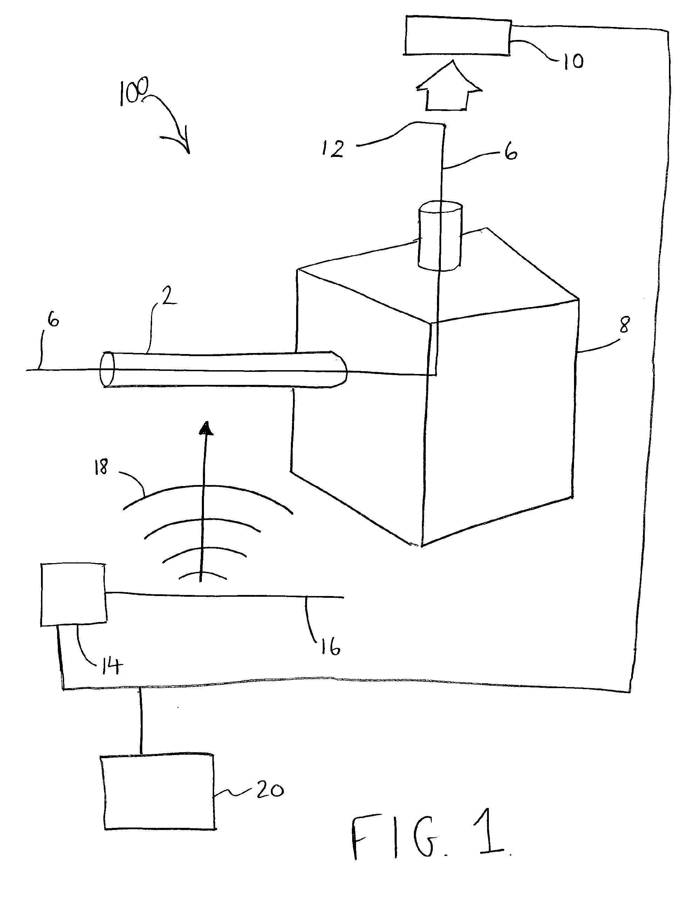

Figure 1 is a schematic illustration (not to scale) showing part of an embodiment of a cable wiring system, hereinafter referred to as the first cable wiring system 100. In this embodiment, the first cable wiring system 100 is located onboard an aircraft.

In the first cable wiring system 100, a screened cable 2 comprises internal conductors within an internal coaxial screen (not shown). In some embodiments, the internal screening may be provided by an electrical conductor (for example, of woven electrically conductive wires) that surrounds signal wires that are to be shielded from electromagnetic interference or that are emitters of electromagnetic interference. In some embodiments, the internal screening may be provided by coupling conductive wires, strands or strips to cable bundles, or positioning said wires, strands or strips near to cable bundles. In some embodiments, the internal screening may be provided by routing cables such that they pass close to a structure that is made from a material that is a good electrical conductor. The cables may also be routed such that they do not pass close to holes, gaps or apertures in a surrounding conductive structure through which electromagnetic fields may gain ingress to enclosed volumes containing electrical cables. The cables may also be routed such that they do not pass close to sources of electromagnetic interference such as emissive cables or equipment.

These internal conductors within the coaxial screen are protected from effects of EMH by the coaxial screen. In other words, the internal conductors within the coaxial screen are "screened" (i.e. "shielded") from electromagnetic radiation or hazards originating from outside the coaxial screen. The coaxial screen is a form of "electromagnetic screening". The terminology "electromagnetic screening" or "electromagnetic shielding" of a component is used herein to the blocking (at least to some extent) of electromagnetic radiation from being incident upon that component. Electromagnetic screening attempts to isolate electrical devices within the screening from the 'outside world', and to isolate wires within cables from the environment through which the cable runs. Electromagnetic screening can reduce the coupling of radio waves, electromagnetic fields and electrostatic fields.

The cable 2 further comprises a probe wire 6 formed in an outer jacket of the cable 2. The probe wire 6 is screened from the internal conductors of the cable 2 by the internal coaxial screen. In some embodiments, the probe wire 6 is not screen from the internal conductors of the cable. In this embodiment, the probe wire 6 is embedded in an outer jacket of the cable 2. Also, the probe wire 6 is a screened wire within the cable 2, i.e. the probe wire 6 is protected, by the screening, from the effects of EMH.

The cable 2 (including the probe wire 6) is coupled to equipment 8, which is a system onboard the aircraft.

In this embodiment, a sensor 10 for sensing/measuring electrical current in probe wire 6 is connected to one end 12 of the probe wire 6. In other embodiments, the sensor 10 may be located at a different location along the probe wire 6, e.g. the sensor 10 may be connected to or built into the equipment 8.

In this embodiment, first cable wiring system 100 further comprises a transmitter unit 14 which is for radiating, from an antenna 16, an illuminating illumination signal 18. The illumination signal 18 radiated from the antenna 16 is incident onto the probe wire 6. The illumination signal 18 and the probe wire 6 are such that, when the illumination signal 18 is incident onto the probe wire 6, a current is induced in the probe wire 6. This current within the probe wire 6 is dependent on the integrity of the cable screening in which the probe wire 6 is embedded. For example, if the cable screening is damaged, current flow within the probe wire 6 tends to be affected. For example, if the cable screening is damaged, current flow within the probe wire 6 would tend to increase. In some embodiments, if the cable screening is damaged, voltages across open circuit terminations (e.g. open switches) will tend to increase, possibly resulting in an electrical discharge across the open circuit terminations.

In this embodiment, the transmitter 14 and antenna 16 are installed within the aircraft within a fixed installation. However, in other embodiments, the transmitter 14 may be provided by equipment that is external to the aircraft, which may be brought up to the aircraft for testing purposes and is mounted on a specially designed seat for fitting to the aircraft to produce reproducible measurements.

In this embodiment, the first cable wiring system 100 further comprises a processor 20 that is coupled to both the sensor 10 (such that signals measured by the sensor 10 may be transmitted from the sensor 10 to the processor 20) and the transmitter 14 (such that a signal indicative of the illumination signal 18 may be transmitted from the transmitter 14 to the processor 20). In other embodiments, the processor 20 may control the transmitter 14, e.g. such that the transmitter 14 causes radiation of an illumination signal having predetermined or known properties or characteristics. In this embodiment, the processor 20 is further coupled to the cable 2 such that a signal indicative of a current within the internal conductors of the cable 2 that are within the internal coaxial screen may be provided to the processor 20.

Figure 2 is a process flow chart showing certain steps of an embodiment of a process of assessing the integrity of the screening of the cable 2 of the first cable wiring system 100.

At step s2, the transmitter 14 is switched on.

At step s4, the switching on of the transmitter 14 causes the illumination signal 18 to be radiated from the antenna 16 on to the probe wire 6. The illumination signal 18 is also incident on the coaxial screen of the cable 2 in which the internal conductors of the cable 2 are housed.

At step s6, if the coaxial screen of the cable 2 is compromised (e.g. damaged), the illumination signal 18 induces a current within the probe wire 6. Also, the illumination signal 18 also induces a current within the internal conductors of the cable 2.

At step s8, the sensor 10 measures the current induced within the probe wire 6.

At step s9, the processor receives: (a) from the sensor 10, the measurement of the current induced within the probe wire 6 taken by the sensor 10 at step s8; (b) from the transmitter 14, the a signal that is indicative of the characteristics or properties of the illumination signal 18 radiated by the antenna 16 at step s4; and (c) from the cable 2, a signal indicative of a current within the internal conductors of the cable 2 that are within the internal coaxial screen.

At step s10, using the information received by the processor 20 at step s9, the processor 20 determines a coupling between the current induced within the probe wire 6 and the illumination signal 18. If the cable screen has been damaged or has deteriorated, then the external field source (i.e. the antenna 16 emitting the illumination signal 18) will couple more effectively onto the probe wire 6 within the cable and a higher current or voltage will be detected on the probe wire 6. In some embodiments, the processor 20 determines a coupling between the current induced within the probe wire 6 and the current within the internal conductors of the cable 2 that are within the internal coaxial screen. In other words, the processor 20 may determine the coupling between the probe wire 6 and the conductors within the cable 2.

At step s12, the processor 20 compares the coupling determined at step s10 to a predetermined benchmark coupling so as to assess the integrity of the cable screening (i.e. to assess a level of protection provided to the internal conductors by the cable screening against EMH). In this embodiment, the predetermined benchmark coupling comprises calibration values recorded when the first cable wiring system 100 was installed into the aircraft, i.e. the predetermined benchmark coupling is indicative of correctly functioning cable screening.

The comparison performed by the processor 20 at step s12 may, for example, comprise determining or inferring that, if the difference between the coupling determined at step s10 and the benchmark coupling is greater than or equal to a predetermined threshold value (i.e. the difference between the couplings is "significant"), then the screening of the cable 2 offers insufficient protection against EMH to the internal conductors of the cable 2. Also, the processor 20 may determine or infer that, if the difference between the coupling determined at step s10 and the benchmark coupling is less than the predetermined threshold value (i.e. the difference between the couplings is "insignificant"), then the screening of the cable 2 offers sufficient protection against EMH to the internal conductors of the cable 2. In other embodiments, the comparison performed by the processor 20 at step s12 may be performed in a different appropriate way.

In other embodiments, the processor 20 compares the measurement of the current taken by the sensor 10 at step s8 with a benchmark current value so as to determine the integrity of the cable screening.

Thus, a process in which the integrity of the screening of the cable 2 is assessed is provided. In this process, the probe wire 6 which is within the screened cable 2 (i.e. is screened from the antenna 16) is illuminated with radiation radiated from the antenna 16, and the coupling of the probe wire 6 to the antenna 16 is measured to assess the effectiveness of the EMH protection offered by the cable screen.

Figure 3 is a schematic illustration (not to scale) showing part of a further embodiment of a cable wiring system, hereinafter referred to as the second cable wiring system 102. In this embodiment, the second cable wiring system 102 is located onboard an aircraft. Also, the second cable wiring system 102 is protected from effects of EMH and in particular all cables within the second cable wiring system 102 are screened.

In Figure 3, components of the second cable wiring system 102 that are the same as those of the first cable wiring system 100 (described in more detail above with reference to Figure 1) are indicated by the same reference numeral.

As in the first cable wiring system 100, in the second cable wiring system 102, the screened cable 2 comprises internal conductors within an internal coaxial screen (not shown).

The cable 2 further comprises a probe wire 6 formed in an outer jacket of the cable 2. In this embodiment, the probe wire 6 is a screened wire, i.e. the probe wire 6 is protected, by screening, from the effects of EMH. For example, the probe wire may be within the coaxial screen of the cable 2. Preferably, the probe wire 6 is also screened from the internal conductors of the cable 2 e.g. by further screening.

The cable 2 (including the probe wire 6) is coupled to equipment 8, which is a system onboard the aircraft.

In this embodiment, a generator of radio frequency (RF) radiation (hereinafter referred to as the "signal source" and indicated in Figure 3 by the reference numeral 21) is connected to one end 12 of the probe wire 6. In other embodiments, the signal source 21 may be located at a different location along the probe wire 6, e.g. the signal source 21 may be connected to or built into the equipment 8.

The signal source 21 is for providing an RF signal along the probe wire 6 (i.e. the signal source 21 injects a signal into one end 12 of the probe wire 6). This causes the probe wire 6 to radiate/generate a signal, hereinafter referred to as the radiated signal 22. In this embodiment, the radiated signal 22 is screened to some extent by the screening applied to the probe wire 6, unless that screening is compromised to an extent that no screening is provided to the probe wire 6.

In this embodiment, second cable wiring system 102 further comprises a further antenna 24 upon which the radiated signal 22 is incident (unless the radiated signal 22 is completely screened by the screening applied to the probe wire 6). The radiated signal 22 incident upon the further antenna 24 induces a signal in the further antenna 24. A receiver 26 is coupled to the further antenna 24 such that the induced signal within the further antenna 24 (induced by the radiated signal 22) is received/measured by the receiver 26.

In this embodiment, the receiver 26 and further antenna 24 are installed within the aircraft within a fixed installation. However, in other embodiments, the receiver 26 and further antenna 24 may be provided by equipment that is external to the aircraft, which may be brought up to the aircraft for testing purposes and is mounted on a specially designed seat for fitting to the aircraft to produce reproducible measurements.

In this embodiment, the second cable wiring system 102 further comprises a processor, hereinafter referred to as the further processor 28, that is coupled to the receiver 26 (such that signals measured/received by the receiver 26 may be transmitted from the receiver 26 to the further processor 28). In this embodiment, the further processor 28 is also be coupled to the signal source 21 (such that a signal indicative of the signal provided/injected into the probe wire 6 may be transmitted from the signal source 21 to the further processor 28), however, in other embodiments this is not the case. In other embodiments, the further processor 28 may control the signal source 21, e.g. such that the signal source 21 provides a signal to the probe wire 6, thereby causing radiation, by the probe wire 6, of a signal having predetermined or known properties or characteristics.

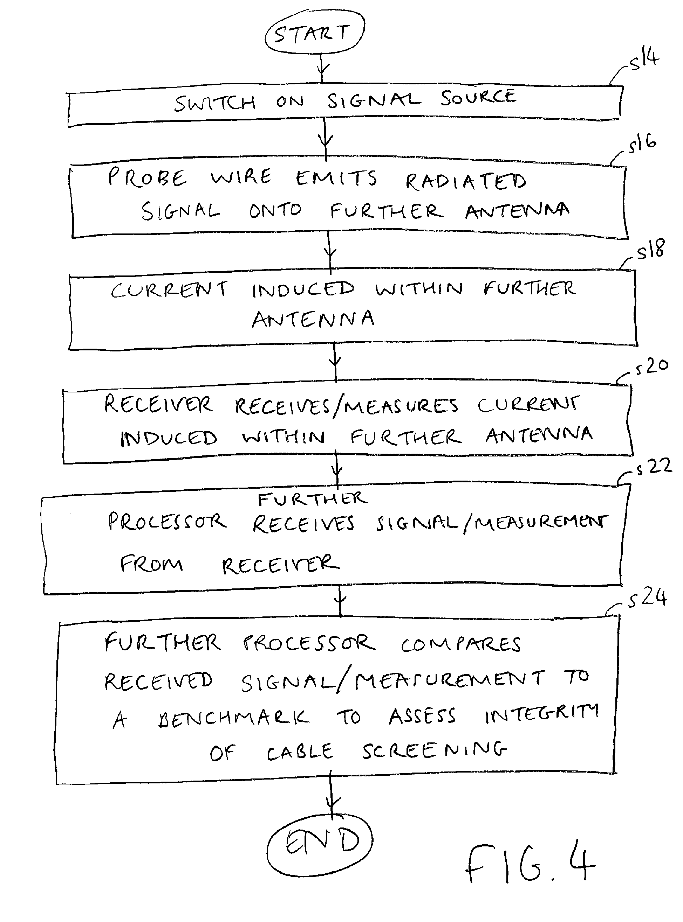

Figure 4 is a process flow chart showing certain steps of an embodiment of a process of assessing the integrity of the screening of the cable 2 of the second cable wiring system 102.

At step s14, the signal source 21 is switched on.

At step s16, the switching on of the signal source 21 causes the signal source 21 to provide an RF signal to the probe wire 6. This causes the probe wire 6 to generate/radiate the radiated signal 22 which, if not completely screened by the screening applied to the probe wire 6, is incident on the further antenna 24.

At step s18, if not completely screened by the screening applied to the probe wire 6, the radiated signal 22 induces a signal within the further antenna 24.

At step s20, the receiver 26 receives the signal induced within the further antenna 24.

At step s22 the further processor 28 receives, from the receiver 26, the received signal induced within the further antenna 24 and received by the receiver 26 at step s20. In some embodiments, the processor 28 further receives, from the signal source 21, the RF signal that is provided along the probe wire 6 by the signal source 21 at step s16.

At step s24, using the information received by the further processor 28 at step s22, the further processor 28 assesses the integrity of the cable screening.

In this embodiment, if the cable screening has not deteriorated and is not damaged (i.e. the screening is performing its screening function well), relatively little of the electric field emitted by the probe wire 6 will escape through the screen. However, if the screen is damaged or has deteriorated, more of the electric field emitted by the probe wire 6 will escape through the screening and be incident upon the further antenna 24. Therefore, if the signal measured within the further antenna 24 has increased from an original "good" test case (i.e. a predetermined benchmark that may be determined at installation of system on the aircraft), in this embodiment it is assumed that the screen is damaged or has deteriorated in some way, i.e. it is determined that the cable screening has a reduced effectiveness as an electromagnetic shield.

In other words, the further processor 28 compares the signal induced within the further antenna 24 to a predetermined benchmark signal so as to assess the integrity of the cable screening (i.e. to assess a level of protection provided to the internal conductors by the cable screening against EMH). In this embodiment, the predetermined benchmark signal is a calibration signal recorded when the second cable wiring system 102 was installed into the aircraft, i.e. the predetermined benchmark coupling is indicative of correctly functioning cable screening. In other embodiments, the further processor 28 performs a different appropriate process with the information it receives so as to assess the integrity of the cable screening.

Thus, a further process in which the integrity of the screening of the cable 2 is assessed is provided. In this embodiment, the probe wire 6 which is within the screened cable 2 (i.e. is screened from the further antenna 24) is excited with a test signal, and the unscreened further antenna 24 positioned outside the screen but adjacent to the screened probe wire 6 is monitored to assess the effectiveness of the EMH protection offered by the cable screen.

Advantageously, a method and means is proposed by which the health of electromagnetic hazards protection installed in an aircraft or other structure may be monitored continuously or periodically e.g. through the entire life of that aircraft or other structure.

Advantageously, the above described apparatus and methods for assessing the integrity of cable screening are applicable not only to aircraft but to any other vehicle or ground installation that has installed measures for protection from EMH. Examples of systems upon which the above described methods and apparatus may be implemented include, without limitation, aircraft, ships and spacecraft, both military and civil, military vehicles of all descriptions, military and RF radar and wireless ground installations

The above described apparatus and methods may be advantageously implemented on any structure containing electrical and electronic devices interconnected by a network of cables and wires. The methods and apparatus may be advantageously used to assess protection against the effects of EMH which may, e.g., be provided by specific measures installed in a system. For example, in a system in which cables and wires that are sensitive to harmful effects of EMH are contained in electromagnetic screens, the above described methods and apparatus may be advantageously used to assess the protection offered by those electromagnetic screens. The above described methods and apparatus may be advantageously used to identify protection measures that at not operating as desired and may require repair or replacement.

The above described methods and apparatus may be advantageously implemented to test the integrity of cable screens, their earthing, the integrity of cable joints and back shells, and certain parameters of equipment coupled to the screened cable. The above described methods and apparatus provide the means to monitor the state of the cable screens and their bonding to back-shells, and the bonding of connectors to receptacles. This may be performed, for example, to provide a warning of a change that might indicate damage to or failure of any part of the screening.

The above described methods and apparatus may advantageously be implemented to obviate whole vehicle tests and all of the concomitant issues concerning taking it out of operational service for delivery to a test site, tests, return to operational status and return to base, etc. The above described methods and apparatus may advantageously be implemented to give warning when a change in performance of electromagnetic screening, e.g. arising from damage, wear or aging, occurs as opposed to at some time later when the change is discovered.

By suitable placement of probe wires near joints or seams, or by use of "smart materials" with embedded, integral, or implicit sensors, the performance of the screening effectiveness of the structure may be monitored. The terminology "smart materials" is used herein to refer to materials that change one or more of their properties (e.g. colour or reflectivity) when exposed to electric or magnetic fields. The change in a property of a smart material may be proportional to the magnitude of the electric or magnetic field experience by that smart material. "Smart materials" also include materials into which is woven a suitable fibre (e.g. a glass fibre) such that the material acts as a Faraday Rotation sensor for sensing a magnetic field arising from emissions through a cable shield or from the shielded cable.

The performance of the screening effectiveness may be of as much interest for the electromagnetic screening as for the integrity of or corrosion within joints. Thus the invention can be extended to include the screening performance of a material barrier with or without joints. In the case of the emitting wire being within the cable bundle, this could be achieved, e.g., by putting the receiver outside the material barrier or aircraft skin. In the case that the receiver wire is in the cable bundle, this could be achieved, e.g., by putting the emitter outside the barrier or skin. That barrier could be an aircraft structural skin material, a removable panel or openable panel, or it could equally be a "smart material".

Using probes inherent in smart structural materials, it advantageously tends to be possible to detect changes in the structural performance of e.g. joints or fasteners. Similarly, the detection of changes in local material properties tends to be possible. For example, the above described methods and apparatus may be used to detect the presence (or lack thereof) of a certain material, e.g. a liquid such as fuel, hydraulic fluid, etc.

The electromagnetic radiation passing from emitter to receiver may be measured at the building of the system to characterise the system's initial state. This measurement may then be compared against future measurements to monitor for changes throughout system life.

Apparatus, including the processor and/or further processor, for implementing the arrangements described above with reference to Figures 1 and 3, and performing the method steps described above with reference to Figures 2 and 4, may be provided by configuring or adapting any suitable apparatus, for example one or more computers or other processing apparatus or processors, and/or providing additional modules. The apparatus may comprise a computer, a network of computers, or one or more processors, for implementing instructions and using data, including instructions and data in the form of a computer program or plurality of computer programs stored in or on a machine readable storage medium such as computer memory, a computer disk, ROM, PROM etc., or any combination of these or other storage media.

It should be noted that certain of the process steps depicted in the flowchart of Figures 2 and 4 and described above may be omitted or such process steps may be performed in differing order to that presented above and shown in Figures 2 and 4. Furthermore, although all the process steps have, for convenience and ease of understanding, been depicted as discrete temporally-sequential steps, nevertheless some of the process steps may in fact be performed simultaneously or at least overlapping to some extent temporally.

In the above embodiments, the probe wire used to receive the illumination signal, or emit the radiated signal, is a wire. However, in other embodiments, a different type of electrical conductor is used.

In the above embodiments, the antenna/further antenna used to emit the illumination signal, or receive the radiated signal, is an antenna. However, in other embodiments, a different type of conductor is used.

In the above described methods and apparatus an extra wire is included alongside installed cables. The additional wire is linked to a test connector on equipment so that test signals can be injected or measured. However, in other embodiments, no additional wire is used, and a wire, or other conductor, already present within the system is used as the probe wire. In some embodiments, for example in systems which implement built-in test equipment (BITE) function, signals applied to emitting conductors (that generate the illuminating/radiated signals) may be specially devised signals or pseudorandom binary sequences on existing wires within cables. A digital signature for each cable would enable receiving apparatus to identify and log each cable response. This implementation of the idea would not only reduce additional weight to be carried by removing the need for additional wires, but would also work equally well on small cables in bundles without over-shielding.

In some embodiments, a permanent signal measuring facility or a signal source for the additional wire may be included within the equipment.

In some embodiments provision may be made, either as part of the permanent installation or as a platform, for sensors and measurement instruments or signal sources separate from aircraft systems or externally to aircraft.

In the above embodiments, the screened cable is a cable comprising an internal coaxial conductor. However, in other embodiments the screened cable may be a different type of cable, e.g. a cable positioned, along with one or more further conductors, within a conductive duct that serves as a cable screening. In some embodiments the cable screening is provided by a conductive panel or external skin of the aircraft or other structure.

In some embodiments, the probe wire may be an unscreened wire. In such embodiments, a coupling between the unscreened probe wire and the screened cable conductors may be used to assess the integrity of the cable screening. This unscreened probe wire may be a special purpose wire formed in a screened cable, but external of the screen. Alternatively it may be positioned alongside the cable. In some cases an external wire may already be provided, for example for expansion purposes for installing additional equipment. Where the cable is located in ducting the unscreened wire may be mounted outside the ducting or, where the ducting comprises "smart" material within the ducting material. Similarly where the screening comprises structural panels or internal skins the unscreened probe wire may be mounted within such "smart" material forming the skin or panel.

In some cases, a screened cable may rely on further screening effect of external panels for full EMH protection. In other cases an aircraft may home all electrical equipment and wiring within an inner electromagnetic cage providing EMH protection.

In some of the above embodiments, an additional unscreened wire is embedded into each cable to be monitored and a connector either built into the equipment to which it connects, or positioned to attach external apparatus to the equipment with direct access to that embedded wire. Then, by illuminating the cable with a calibrated electromagnetic field, either from a fixed source within the structure or from a portable source at a specially provided site, the coupling onto the embedded unscreened wire may be measured to obtain an absolute and/or a relative measure of the screening performance of the cable which, when compared with calibrated as-built standards will signify any change in that screening performance. The process can equally be reversed so that the embedded wire may be excited with a signal from the equipment at one end of the cable and the screening be measured by what can be measured on a wire or probe outside the cable.

In some embodiments, probe wires in different cables may be excited using illuminating signals having different frequencies. Thus, it advantageously tends to be possible to assess the performance/integrity of many cable screens simultaneously and/or continuously.

In some embodiments, the signals "injected" into emitting conductors may be continuous waves having a specific frequency or many frequencies. In some embodiments, the signals "injected" into emitting conductors may comprise pulses having energies at many or a continuum of frequencies. In some embodiments, the signals "injected" into emitting conductors may be a pseudo random binary sequence. A pseudo random binary signal may be of very low amplitude (e.g. at or below the noise level of the system) and still capable of being measured. Thus, a pseudo random binary signal may be advantageously injected onto a wire that is used for other purpose, e.g. either a signal or power wire, without disrupting the function of that wire, thereby removing the need for an additional wires to be provided.

In some embodiments, an entire aircraft system designed to implement some or all of the above described methods and apparatus is provided. Such an aircraft may comprise a central system monitor computer to receive performance information from equipment equipped to measure the electromagnetic performance of installed systems and structures. The central computer may report major deviations in electromagnetic performance of installed systems to the aircraft pilot. Also, the central computer may report major and minor deviations in electromagnetic performance of installed systems to aircraft ground crew. The above described apparatus may be combined with structural health monitoring and contribute to the information available on structural health.

In the above embodiments, the above described methods and apparatus are used to assess the integrity of cable screening. However, in other embodiments, the above described methods and apparatus are implemented to assess, determine, or monitor a different system property or characteristic. For example, the health of a mechanical structural joint within an aircraft may be monitored. The health of a mechanical structural joint within an aircraft may affect the structural integrity of the aircraft. In this case, e health of a mechanical structural joint within an aircraft may be monitored by monitoring the electromagnetic characteristics of the joint. A change in such characteristics may indicate for example corrosion or cracking within the joint.

## Claims

1. A method of providing an assessment of electromagnetic screening, the method comprising:
providing a first electrical conductor;
providing a second electrical conductor, the second electrical conductor being a different electrical conductor to the first electrical conductor;
providing a third electrical conductor;
providing electromagnetic screening, the electromagnetic screening being arranged such that:
electromagnetic radiation incident upon, or emitted by, the first conductor is blocked, by the electromagnetic screening, at least to some extent; and
electromagnetic radiation, other than that emitted by the first conductor, that is incident upon the second conductor is not blocked by the electromagnetic screening;
electromagnetic radiation, other than that incident upon the first conductor, that is emitted by the second conductor is not blocked by the electromagnetic screening;
applying, to the third conductor, a test signal, thereby causing the third conductor to emit electromagnetic radiation;
measuring a current within either or both of the first and second electrical conductors induced by the electromagnetic radiation emitted by the third conductor; and
using the one or more measurements, determining an assessment of the electromagnetic screening.

2. A method according to claim 1, wherein
the second electrical conductor (16) and the third electrical conductor (16) are the same electrical conductor;
the step of measuring comprises measuring a current induced within the first electrical conductor (6) by the electromagnetic radiation (18) emitted from the second conductor (16).

3. A method according to claim 1, wherein:
the third electrical conductor (16) is a different electrical conductor to the first electrical conductor and the second electrical conductor (6); and
the step of measuring comprises measuring a current within both of the first electrical conductor and the second electrical conductor (6); and
the step of determining an assessment comprises, using the measurements, determining a coupling between the first electrical conductor and second electrical conductor (6), and using the determined coupling, determining an assessment of the electromagnetic screening.

4. A method according to claim 3, wherein the step of determining an assessment further comprises comparing the determined coupling to a predetermined benchmark, the predetermined benchmark being indicative of the electromagnetic screening operating as desired.

5. A method according to claim 3 or 4, wherein:
the first electrical conductor and the electromagnetic screening are components of a cable (2);
the first electrical conductor is an internal conductor within the electromagnetic screening; and
the electromagnetic screening is a coaxial screening housing the first electrical conductor.

6. A method according to claim 5, wherein the second electrical conductor (6) is a conductor embedded into an external jacket of the cable (2) such that it is outside the electromagnetic screening.

7. A method according to claim 1, wherein
the first electrical conductor (6) and the third electrical conductor (6) are the same electrical conductor;
the step of measuring comprises measuring a current induced within the second electrical conductor (24) by the electromagnetic radiation emitted from the first conductor (6).

8. A method according to claim 7, wherein the step of determining an assessment comprises comparing the measuring induced current to a predetermined benchmark, the predetermined benchmark being indicative of the electromagnetic screening operating as desired.

9. A method according to claim 7 or 8, wherein:
the first electrical conductor (6) and the electromagnetic screening are components of a cable (2);
the first electrical conductor (6) is an internal conductor within the electromagnetic screening; and
the electromagnetic screening is a coaxial screening housing the first electrical conductor.

10. A method according to claim 9, wherein the second electrical conductor (24) is a conductor that is remote from the cable (2) and may be moved away from the cable (2) after the determination of the assessment of the electromagnetic screening.

11. A method according to any of claims 1 to 10, wherein the test signal is a pseudo random binary signal.

12. Apparatus comprising:
a first electrical conductor;
a second electrical conductor, the second electrical conductor being a different electrical conductor to the first electrical conductor;
a third electrical conductor;
electromagnetic screening arranged such that:
electromagnetic radiation incident upon, or emitted by, the first conductor is blocked, by the electromagnetic screening, at least to some extent; and
electromagnetic radiation, other than that emitted by the first conductor, that is incident upon the second conductor is not blocked by the electromagnetic screening;
electromagnetic radiation, other than that incident upon the first conductor, that is emitted by the second conductor is not blocked by the electromagnetic screening;
a signal source configured to apply, to the third conductor, a test signal, thereby causing the third conductor to emit electromagnetic radiation;
a sensor operatively coupled to either or both of the first and second electrical conductors and configured to measure a current within the electrical conductors to which the sensor is coupled that has been induced by the electromagnetic radiation emitted by the third conductor; and
a processor operatively coupled to the sensor and configured to, using the one or more sensor measurements, determine an assessment of the electromagnetic screening.

13. An aircraft comprising apparatus in accordance with claim 12.

14. A program or plurality of programs arranged such that when executed by a computer system or one or more processors it/they cause the computer system or the one or more processors to operate in accordance with the method of any of claims 1 to 11.

15. A machine readable storage medium storing a program or at least one of the plurality of programs according to claim 14.
